# EUROPEAN PATENT SPECIFICATION

(11) **EP 1 211 679 B1**
(45) Date of publication and mention of the grant of the patent: **19.10.2005**
(21) Application number: 99937041.4
(22) Date of filing: 12.08.1999
(51) Int. Cl.: G11B 7/26, G11B 7/24, C23C 14/34, C23C 14/08, B41M 5/26, G02B 1/10

(54) **LIGHT-TRANSMITTING FILM AND SPUTTERING TARGET FOR FORMING THE LIGHT-TRANSMITTING FILM**
LICHTDURCHLASSENDE SCHICHT UND SPUTTERTARGET ZUR HERSTELLUNG DIESER SCHICHT
FILM PHOTOEMETTEUR ET CIBLE DE PULVERISATION POUR FORMER CE FILM PHOTOEMETTEUR

(43) Date of publication of application: 05.06.2002
(73) Proprietor: Nikko Materials Co., Ltd., Tokyo 105-8407 (JP)
(72) Inventor: KUWANO, Katsuo, Isohara Factory of Nikko Materials, Kitaibaraki-shi, Ibaraki-ken 319-1535 (JP); TAKAMI, Hideo, Isohara Factory of Nikko Materials, Kitaibaraki-shi, Ibaraki-ken 319-1535 (JP)
(74) Representative: Meddle, Alan L.
(86) International application number: PCT/JP1999/004365
(87) International publication number: WO 2001/013371

(56) References cited:
- JP-A- 3 152 736
- JP-A- 11 185 294
- JP-A- 60 045 952
- JP-B2- 2 887 322
- US-A- 5 736 267
- PATENT ABSTRACTS OF JAPAN vol. 1999, no. 11, 30 September 1999 (1999-09-30) & JP 11 171539 A (SUMITOMO METAL MINING CO LTD), 29 June 1999 (1999-06-29)

## Description

### TECHNICAL FIELD

The present invention relates to an optically transparent film especially used in a protective film (hereafter including a material expressed as a "layer") for optical disks, more specifically to an optically transparent film that can decrease the number of particles formed during the formation of a film with sputtering, that has a high transmittance in the visible region of the formed film, and that is suitable for an optical disk having a low reflectance, in particular for a phase-change type optical disk; and a sputtering target for forming such a film.

### BACKGROUND ART

In recent years, high-density optical disks have rapidly attracted public interests because they can record and play without the need of magnetic heads.

These optical disks are classified into three types: the read-only type, the write-once type, and the rewritable type, and the phase-change system used in the write-once type and the rewritable type has particularly attracted public attention. The principle of writing and reading using such a phase-change type optical disk will be described briefly below.

A phase-change type optical disk is used for writing and reading information by heating the recording layer on a substrate by the irradiation of laser beams, and causing crystallographic phase change (between amorphous and crystalline phases) to occur in the structure of the recording layer. More specifically, information is read by sensing change in reflectance caused by change in optical constants between the phases.

The above-described phase change is caused by the irradiation of laser beams narrowed down to a diameter of 1 to several microns. In this case, for example, if laser beams of a diameter of 1 µm pass at a linear velocity of 10 m/s, the time that a certain spot on the optical disk is irradiated is 100 ns, in which the above-described phase change and reflectance must be sensed.

For realizing the above-described crystallographic phase change, i.e. phase change between amorphous and crystalline phases, the heat of melting and quenching is imparted not only to the phase-change recording layer of the optical disk, but also to the surrounding protective film and the reflective film of an aluminum alloy repeatedly.

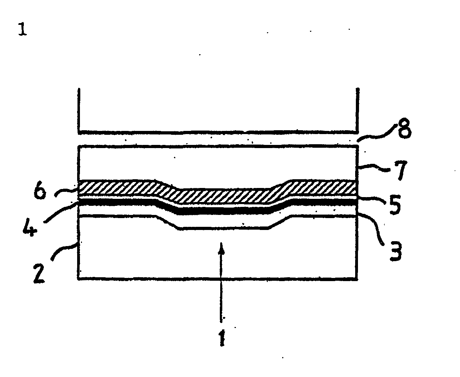

From these facts, as Figure 1 shows, the phase-change optical disk has a four-layer structure in which a Ge-Sb-Te-based recording thin film 4 or the like is sandwiched by protective films 3 and 5 of a ZnS-SiO₂-based high-melting-point dielectric, and further a reflective film 6 of an aluminum alloy is disposed.

Among these, the reflective film 6 and protective films 3, 5 is required to have optical functions to increase the absorption of amorphous and crystalline portions, and to increase difference in reflectance, as well as the function to prevent the distortion of the recording film 4 due to damp-proof or heat, and the function to control the thermal conditions on recording (see "Kogaku (Optics)," Vol. 26, No. 1, pp. 9-15).

As described above, the high melting-point protective films 3, 5 must be resistant to repetitive thermal stress of heating and cooling, the reflective film and other components must not be affected by these thermal effects, and the protective films themselves must be thin and low reflective, and must not be deteriorated. In this sense, the protective films 3, 5 play an important role.

In Figure 1, the symbol 1 represents the laser incident direction, 2 represents a substrate of polycarbonate or the like, 7 represents an overcoat, and 8 represents an adhesive layer.

The above-described protective films 3 and 5 are normally formed by the sputtering method. In this sputtering method, a positive electrode and a target consisting of a negative electrode is made to face to each other, and a high voltage is input between the substrate and the target in an inert gas atmosphere to create an electric field. The method uses the principle in which electrons impinge against the inert gas to form plasma, anions in the plasma impinge on the surface of the target (negative electrode) to knock on atoms constituting the target, and these knock-on atoms are deposited on the facing surface of the substrate to form a film.

As the target for forming the above-described protective films, a ZnS-SiO₂ sputtering target, manufactured by sintering the mixed powder of SiO₂ powder and ZnS powder, has been used. US-A-5,736,267 discloses a sputtering target comprising ZnO, Ga₂O₃ and SiO₂. JP-A-11-171539 discloses a sputtering target comprising ZnO, B₂O₃ and one oxide chosen from Al₂O₃ and Ga₂O₃.

In the stage of forming thin films by sputtering using a ZnS-SiO₂ sputtering target, when the quantity of coating exceed a certain level, cluster-like coarse grains, known as particles, are deposited on the thin film. The main cause of the formation of these particles is that the mist produced by sputtering deposit on the walls of the sputtering chamber and on various apparatuses, it is peeled off as debris when the quantity exceeds a certain level, the debris float within the sputtering chamber, and deposit again on the substrate or the thin film.

Since these particles degrade the properties of the thin film, sputtering must be once suspended in the stage when a large quantity of the particles deposit on the substrate or the thin film, and the sputtering chamber must be opened to remove deposits of the film that cause particles to be formed on the walls of the sputtering chamber and on various apparatuses.

This lowers productivity significantly. Although the reason why these deposits of the film adhere on the walls of the sputtering chamber and on various apparatuses has not been well known, the cause-result relationship has been estimated in the manufacturing process of the ZnS-SiO₂ target, specifically, the mixing and sintering steps of SiO₂ powder and ZnS powder. However, the solution more than the estimation has not been found.

Also, although the protective films formed by sputtering have been required to have a reflectance as low as possible, the feasibility of the improvement in the steps of the manufacturing process of the ZnS-SiO₂ target has not been sufficiently studied.

Especially, the large problem of the above-described conventional ZnS-SiO₂ target is that direct current sputtering cannot be performed because these materials are insulators. Therefore, low-efficiency methods such as high frequency (RF) sputtering must be used. These methods require sputtering for a long time to obtain a desired thickness, and raise an unfavorable problem that the number of particles, which must be decreased, are rather increased.

### DISCLOSURE OF THE INVENTION

The present invention solves the above problems by fundamentally reviewing sputtering target materials to reduce the formation of particles as much as possible, to decrease the frequency of interruption or discontinuance of sputtering to improve production efficiency, and to obtain a protective film for optical disks having a large transmittance and a low reflectance.

According to the present invention, there are provided 1) an optically transparent film containing 0.01 to 20% by weight one or more glass forming oxide selected from a group consisting of Nb₂O₅, V₂O₅, B₂O₃, SiO₂, and P₂O₅; 0.01 to 20% by weight Al₂O₃ or Ga₂O₃; balance being ZnO; 2) the optically transparent film according to the above-described 1), further containing 0.01 to 5% by weight hard oxide of ZrO₂ and/or TiO₂; 3) a sputtering target for forming an optically transparent film containing 0.01 to 20% by weight one or more glass forming oxide selected from a group consisting of Nb₂O₅, V₂O₅, B₂O₃, SiO₂, and P₂O₅; 0.01 to 20% by weight Al₂O₃ or Ga₂O₃; balance being ZnO; and 4) the sputtering target for forming an optically transparent film according to the above-described 3), further containing 0.01 to 5% by weight hard oxide of ZrO₂ and/or TiO₂.

### BRIEF DESCRIPTION OF THE DRAWINGS

Figure 1 is an explanatory sectional view showing a layered structure of thin films for recording; and
Figure 2 is a diagram showing results of X-ray diffraction of a protective film formed by a ZnO-Al₂O₃-Nb₂O₅ target on the Example, heated to 300°C and 400°C.

### BEST MODE FOR CARRYING OUT THE INVENTION

When the optically transparent film of the present invention is used as an optical disk protective film, the sputtering target for forming the film is manufactured by mixing and sintering by hot pressing, HIP, or the like the powders of ZnO as the main component, 0.01 to 20% by weight of one or more glass forming oxide selected from a group consisting of Nb₂O₅, V₂O₅, B₂O₃, SiO₂, and P₂O₅, 0.01 to 20% by weight Al₂O₃ and/or Ga₂O₃, and as required, 0.01 to 5% by weight hard oxide of ZrO₂ and/or TiO₂.

The addition of 0.01 to 20% by weight of at least one of glass forming oxide selected from a group consisting of Nb₂O₅, V₂O₅, B₂O₃, SiO₂, and P₂O₅ is to inhibit crystallization effectively, and to form a stable optical disk protective layer.

The addition of less than 0.01% by weight of the oxide is not effective, and the addition exceeding 20% by weight causes the crystal phase of the added component to precipitate. For the above reasons, the range of addition of the above-described oxide is preferably between 0.01 and 20% by weight.

Further, the reason why the content of Al₂O₃ and/or Ga₂O₃ is 0.01 to 20% by weight is that these oxides lower the bulk electrical resistance of the target, enable direct-current (DC) sputtering, and can maintain the transmittance of the thin film for the protective layer in the visible ray region (360-830 nm) at 80% or more.

The addition of less than 0.01% by weight of the oxide is not effective, and the addition exceeding 20% by weight causes the tendency of electrical insulation to occur, makes stable DC sputtering difficult, and lowers the transmittance of the thin film for the protective layer in the visible ray region.

As required, 0.01 to 5% by weight of hard oxides of ZrO₂ and/or TiO₂ may be added to reinforce the film.

The protective film formed using the above ZnO-based sputtering target for optical disk protective films has a transmittance of 80% or more in the visible region (360-830 nm), and a reflectance of 20% or less. These values are sufficient for optical disk protective films.

The above ZnO-based sputtering target for optical disk protective films of the present invention can significantly reduce the formation of particles compared with conventional ZnS-SiO₂ targets. The reason is considered that ZnO and the additives themselves have larger adhesive force to the internal walls of the chamber and to the apparatus than ZnS.

By thus reducing the formation of particles, since the number of interruption or discontinuance of sputtering decreases, and the frequency of troublesome cleaning of the sputtering chamber decreases, the present invention has the effect of dramatically elevating the production efficiency compared with the conventional sputtering targets.

In addition, the use of the ZnO-based sputtering target for optical disk protective films not only provides the above-described low-reflectance films, but also provides at high reproducibility the stable ZnO-based optical disk protective films (layers) that satisfy optical functions to increase the absorption of the amorphous and crystalline portions and increase the difference in reflectance, the function to prevent the deformation of recording thin films due to damp-proof or heat, and the function to control the thermal conditions during recording.

### Examples and Comparative Examples

The present invention will be described in detail below referring to Examples and Comparative Examples. These examples are solely shown for explanation, and are not intended to limit the present invention. Specifically, the present invention is limited only by the attached claims, and includes various modifications other than the examples of the present invention. Examples suitable for and typical of the present invention will be shown below.

### (Example 1)

An example related to an optical disk protective film will be shown. A target was manufactured by weighing 2% by weight of Al₂O₃ powder and 10% by weight of Nb₂O₅ powder, mixing them with balance ZnO powder, and sintering the mixture in the air at 1400°C. The resultant target had a density of 5.3 g/cm³.

Using the ZnO-Al₂O₃-Nb₂O₅ target thus obtained, sputtering was performed to form a film on a substrate. The sputtering conditions were as follows:

| | |
|---|---|
| Sputter gas | Ar |
| Gas pressure | 0.5 Pa |
| Substrate temperature | room temperature |
| Film thickness | 1500 Angstrom |

The number of substrate coating, i.e. the number of products, until particles on the internal walls of the sputtering chamber and the apparatus had to be cleaned was 3000 to 3500. This was 20%-40% improvement compared with the number of products from the Comparative Examples described below (ZnS-SiO₂ target) .

The reflectance of the protective films was 16-18%, which sufficiently achieved the target value of 20% or less. Furthermore, the transmittance in the visible-ray region was 95%, and the properties of an effective protective film were obtained.

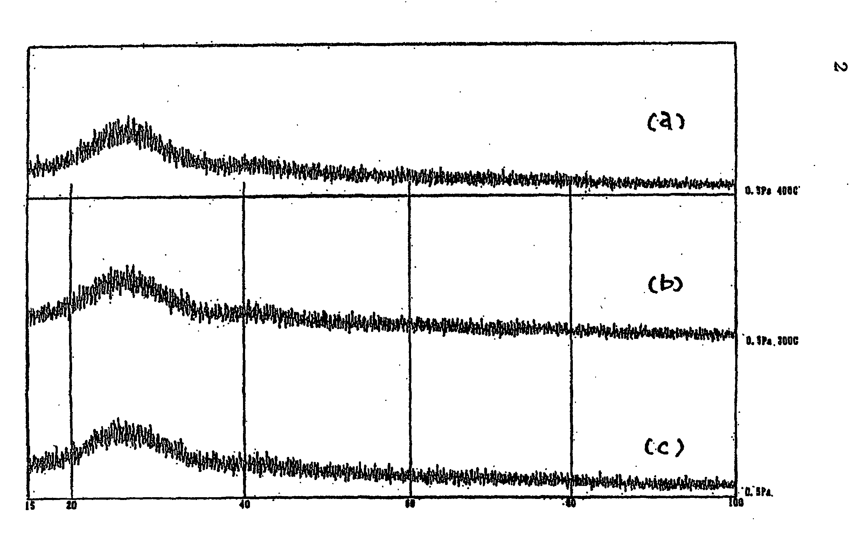

Also, X-ray diffraction data were reviewed to check crystallization when the protective films formed using the ZnO-Al₂O₃-Nb₂O₅ target of the above-described Example 1 were heated to 300°C and 400°C (in the air). For comparison the protective film that was not heated was also tested at the same time. The results are shown in (a), (b), and (c) of Figure 2.

Figure 2(a) shows crystallization when the protective films are heated to 400°C; Figure 2(b), to 300°C; and Figure 2(c), when not heated.

As obviously seen from these results, no crystallization was observed even when heated to 300°C and 400°C (in the air), similar to the protective film without heating. Specifically, the target of the present invention provided stable ZnO-based optical disk protective films without crystallization.

### (Example 2)

A target was manufactured by weighing 2% by weight of Al₂O₃ powder and 5% by weight of SiO₂ powder, mixing them with balance ZnO powder, and sintering the mixture in the air at 1400°C. The resultant target had a density of 5.2 g/cm³.

Using the ZnO-Al₂O₃-SiO₂ target thus obtained, sputtering was performed to form a film on a substrate. The number of substrate coating, i.e. the number of products, until particles on the internal walls of the sputtering chamber and the apparatus had to be cleaned was 3000 to 3500. This was 20%-40% improvement compared with the number of products from the Comparative Examples described below (ZnS-SiO₂ target).

The reflectance of the protective films was 16-18%, which sufficiently achieved the target value of 20% or less. Furthermore, the transmittance in the visible-ray region was 93% or more, and the properties of an effective protective film were obtained.

Also, X-ray diffraction data were reviewed to check crystallization when the protective films formed using the ZnO-Al₂O₃-SiO₂ target of the above-described Example 2 were heated to 300°C (in the air) . No crystallization was observed as in Example 1. Specifically, the target of the present invention provided stable ZnO-based optical disk protective films without crystallization.

### (Example 3)

A target was manufactured by weighing 2% by weight of Ga₂O₃ powder and 10% by weight of Nb₂O₅ powder, mixing them with balance ZnO powder, and sintering the mixture in the air at 1400°C. The resultant target had a density of 5.2 g/cm³.

Using the ZnO-Ga₂O₃-Nb₂O₅ target thus obtained, a film was formed on a substrate by direct current (DC). The number of substrate coating, i.e. the number of products, until particles on the internal walls of the sputtering chamber and the apparatus had to be cleaned was 3000 to 3500. This was 20%-40% improvement compared with the number of products from the Comparative Examples described below (ZnS-SiO₂ target) .

The reflectance of the protective films was 16-18%, which sufficiently achieved the target value of 20% or less. Furthermore, the transmittance in the visible-ray region was 93% or more, and the properties of an effective protective film were obtained.

Also, X-ray diffraction data were reviewed to check crystallization when the protective films formed using the ZnO-Ga₂O₃-Nb₂O₅ target of the above-described Example 3 were heated to 300°C (in the air). No crystallization was observed as in Examples 1 and 2. Specifically, the target of the present invention provided stable ZnO-based optical disk protective films without crystallization.

Although three examples, i.e. an example of Al₂O₃ and Nb₂O₅ added to ZnO, an example of Al₂O₃ and SiO₂ added to ZnO, and an example of Ga₂O₃ and Nb₂O₅ added to ZnO, have been shown above, similar results were obtained when other oxides such as V₂O₅, B₂O₃, and P₂O₅, or the combination of these oxides were added.

Also the similar results were obtained when one or two of ZrO₂ and TiO₂ were added. The above Examples are typical examples.

The number of substrate coating, i.e. the number of products, until particles on the internal walls of the sputtering chamber and the apparatus had to be cleaned in the above Examples 1 to 3 and Comparative Example are collectively shown in Table 1.

**[Table 1]**

| | Number of products before cleaning |
|---|---|
| Example 1 | 3000 - 3500 |
| Example 2 | 3000 - 3500 |
| Example 3 | 3000 - 3500 |
| Comparative Example | 2500 |

### (Comparative Example)

Next, 20 mol% of SiO₂ powder and 80 mol% of ZnS powder were mixed, and hot-pressed in an Ar atmosphere at 1000°C and 150 kgf/cm². The resultant target had a density of 3.4 g/cm³.

Using the ZnS-SiO₂ target thus obtained, high frequency (RF) sputtering was performed. The number of substrate coating, i.e. the number of products, until particles on the internal walls of the sputtering chamber and the apparatus had to be cleaned was 2500. This was about 30% less than Examples.

Furthermore, the reflectance of the protective film formed by sputtering was higher, and the transmittance was lower than expected.

The deviation of the composition of formed film from the composition of the sputtering targets in the above Examples and Comparative Examples was within ±10% for each component.

### INDUSTRIAL APPLICABILITY

The optically transparent film of the present invention, when used as an optical disk protective film, has excellent features to significantly decreasing the formation of particles, improving the uniformity of the film, and providing a protective film that has low reflectance and high transmittance in the visible region under stable production conditions at high reproducibility, by using a ZnO-based sputtering target for optical disk protective films that substitutes conventional ZnS-SiO₂ sputtering targets.

As described above, the protective film for optical disks, especially for phase-change type optical disks, formed using the sputtering target of the present invention has an excellent effect to form stable films without deterioration of properties of the protective film even subjected to repetitive heating-cooling heat cycles of the phase-change recording layer by laser beams.

Furthermore, as described above, the ZnO-based sputtering target of the present invention has significant features to not only provide the films of lower reflectance, but also to provide at high reproducibility the stable films that satisfy optical functions to increase the absorption of the amorphous and crystalline portions and increase the difference in reflectance, the function to prevent the deformation of recording thin films due to damp-proof or heat, and the function to control the thermal conditions during recording.

## Claims

1. An optically transparent film comprising:
0.01 to 20% by weight of at least one glass forming oxide selected from the group consisting of Nb₂O₅, V₂O₅ and P₂O₅;
0.01 to 20% by weight of one of Al₂O₃ and Ga₂O₃; and
a balance of ZnO.

2. An optically transparent film according to claim 1 comprising
0.01 to 20% by weight of at least one glass forming oxide selected from the group consisting of B₂O₃ and SiO₂.

3. An optically transparent film according to claim 1 or 2 comprising
0.01 to 5% by weight of a hard oxide including ZrO₂.

4. A sputtering target for forming an optically transparent film, comprising:
0.01 to 20% by weight of at least one glass forming oxide selected from the group consisting of Nb₂O₅, V₂O₅ and P₂O₅;
0.01 to 20% by weight of one of Al₂O₃and Ga₂O₃; and
a balance of ZnO.

5. A sputtering target according to claim 4 comprising 0.01 to 20% by weight of at least one glass forming oxide selected from the group consisting of B₂O₃ and SiO₂.

6. A sputtering target according to claim 4 or 5 comprising 0.01 to 5% by weight of a hard oxide including ZrO₂.

7. An optical disc, comprising:
a recording layer on which information is written by irradiation of laser beams which crystallographic phase change of a structure of said recording layer and
from which information is read by sensing a change in the reflectance of said recording layer between said crystallographic phase changes of said structure; and
a pair of optically transparent protective films located on opposite sides of said recording layer to sandwich said recording layer therebetween, each of said optically transparent protective films comprising: 0.01 to 20% by weight of at least one glass forming oxide selected from the group consisting of Nb₂O₅, V₂O₅, and P₂O₅; 0.01 to 20% by weight of one of Al₂O₃ and Ga₂O₃; and a balance of ZnO.

8. An optical disc according to claim 7 wherein each of said optically transparent protective films comprises 0.01 to 20% by weight of at least one glass forming oxide selected from the group consisting of B₂O₃ and SiO₂.

9. An optical disc according to claim 7 or 8 wherein each of said optically transparent protective films comprises 0.01 to 5% by weight of a hard oxide including ZrO₂.

## Patentansprüche

1. Optisch durchlässiger Film, der folgendes umfaßt:
0,01 bis 20 Gewichtsprozent mindestens eines glasbildenden Oxids ausgewählt aus der Gruppe bestehend aus Nb₂O₅, V₂O₅ und P₂O₅;
0,01 bis 20 Gewichtsprozent von Al₂O₃ oder Ga₂O₃ und Rest ZnO.

2. Optisch durchlässiger Film nach Anspruch 1, der folgendes umfaßt:
0,01 bis 20 Gewichtsprozent mindestens eines glasbildenden Oxids ausgewählt aus der Gruppe bestehend aus B₂O₃ und SiO₂;

3. Optisch durchlässiger Film nach Anspruch 1 oder 2, der 0,01 bis 5 Gewichtsprozent eines harten Oxids einschließlich ZrO₂ umfaßt.

4. Sputterziel zum Ausbilden eines Optisch durchlässigen Films, umfassend:
0,01 bis 20 Gewichtsprozent mindestens eines glasbildenden Oxids ausgewählt aus der Gruppe bestehend aus Nb₂O₅, V₂O₅ und P₂O₅;
0,01 bis 20 Gewichtsprozent von Al₂O₃ oder Ga₂O₃ und Rest ZnO.

5. Sputterziel nach Anspruch 4, umfassend:
0,01 bis 20 Gewichtsprozent mindestens eines glasbildenden Oxids ausgewählt aus der Gruppe bestehend aus B₂O₃ und SiO₂;

6. Sputterziel nach Anspruch 4 oder 5 mit 0,01 bis 5 Gewichtsprozent eines harten Oxids einschließlich ZrO₂.

7. Optische Platte, die folgendes umfaßt:
eine Aufzeichnungsschicht, auf der Informationen durch Strahlung von Laserstrahlen geschrieben werden, die die kristallographische Phase einer Struktur der Aufzeichnungsschicht ändern, und von der Informationen gelesen werden durch Erfassen einer Änderung beim Reflexionsvermögen der Aufzeichnungsschicht zwischen den kristallographischen Phasenänderungen der Struktur; und
ein Paar Optisch durchlässiger Schutzfilme, die sich auf gegenüberliegenden Seiten der Aufzeichnungsschicht befinden, um die Aufzeichnungsschicht dazwischen zu schichten, wobei jeder der Optisch durchlässigen Schutzfilme folgendes umfaßt: 0,01 bis 20 Gewichtsprozent mindestens eines glasbildenden Oxids ausgewählt aus der Gruppe bestehend aus Nb₂O₅, V₂O₅ und P₂O₅; 0,01 bis 20 Gewichtsprozent von Al₂O₃ oder Ga₂O₃ und Rest ZnO.

8. Optische Platte nach Anspruch 7, wobei jeder der optisch durchlässigen Schutzfilme 0,01 bis 20 Gewichtsprozent mindestens eines glasbildenden Oxids ausgewählt aus der Gruppe bestehend aus B₂O₃ und SiO₂ umfaßt.

9. Optische Platte nach Anspruch 7 oder 8, wobei jeder der optisch durchlässigen Schutzfilme 0,01 bis 5 Gewichtsprozent eines harten Oxids einschließlich ZrO₂ umfaßt.

## Revendications

1. Film optiquement transparent composé :
pour 0,01 à 20% du poids, d'au moins un oxyde formant du verre choisi parmi le groupe consistant en Nb₂O₅, V₂O₅ et P₂O₅ ;
pour 0,01 à 20% du poids, de l'un de Al₂O₃ et Ga₂O₃ ; et un complément de ZnO.

2. Film optiquement transparent selon la revendication 1 composé pour 0,01 à 20% du poids, d'au moins un oxyde formant du verre choisi parmi le groupe consistant en B₂O₃ et SiO₂.

3. Film optiquement transparent selon la revendication 1 ou 2 composé pour 0,01 à 5% du poids, d'un oxyde dur incluant le ZrO₂.

4. Cible de sputtering pour constituer un film optiquement transparent, composé :
pour 0,01 à 20% du poids, d'au moins un oxyde formant du verre choisi parmi le groupe consistant en Nb₂O₅, V₂O₅ et P₂O₅ ;
pour 0,01 à 20% du poids, de l'un de Al₂O₃ et Ga₂O₃ ; et un complément de ZnO.

5. Cible de sputtering selon la revendication 4 composé pour 0,01 à 20% du poids, d'au moins un oxyde formant du verre choisi parmi le groupe consistant en B₂O₃ et SiO₂.

6. Cible de sputtering selon la revendication 4 ou 5 composé pour 0,01 à 5% du poids, d'un oxyde dur incluant le ZrO₂.

7. Disque optique composé :
d'une couche d'enregistrement sur laquelle on inscrit des informations par irradiation au moyen de faisceaux lasers qui changent la phase cristallographique d'une structure de ladite couche d'enregistrement et dont on peut lire les informations en lisant un changement de la réflectance de ladite couche d'enregistrement entre lesdits changements de phase cristallographiques de ladite structure ; et
une paire de films de protection optiquement transparents situés sur les faces opposés de ladite couche d'enregistrement pour intercaler ladite couche d'enregistrement entre elles, chacun desdits films de protection optiquement transparents étant composé : pour 0,01 à 20% du poids, d'au moins un oxyde formant du verre choisi parmi le groupe consistant en Nb₂O₅, V₂O₅ et P₂O₅ ; pour 0,01 à 20% du poids, de l'un de Al₂O₃ et Ga₂O₃ ; et un complément de ZnO.

8. Disque optique selon la revendication 7 dans lequel chacun desdits films de protection optiquement transparents est composé pour 0,01 à 20% du poids, d'au moins un oxyde formant du verre choisi parmi le groupe consistant en B₂O₃ et SiO₂.

9. Disque optique selon la revendication 7 ou 8 dans lequel chacun desdits films de protection optiquement transparents est composé pour 0,01 à 5% du poids, d'un oxyde dur incluant le ZrO₂.
